# EUROPEAN PATENT SPECIFICATION

(11) **EP 0 691 803 B1**
(45) Date of publication and mention of the grant of the patent: **30.12.1998**
(21) Application number: 95110465.2
(22) Date of filing: 05.07.1995
(51) Int. Cl.: H05K 7/20

(54) **Heat radiating member made of highly oriented graphite**
Wärmeausstrahlendes Bauelement aus Hochorientiertem Graphit
Elément rayonnant la chaleur en graphite à haut degré d'orientation

(30) Priority: 06.07.1994 JP 154627/94
(43) Date of publication of application: 10.01.1996
(73) Proprietor: MATSUSHITA ELECTRIC INDUSTRIAL CO., LTD., Kadoma-shi, Osaka-fu, 571 (JP)
(72) Inventor: Inoue, Takao, Hirakata-shi, Osaka-fu (JP); Ikeda, Junji, Ikoma-shi, Nara-ken (JP); Nishiki, Naomi, Kyoto-shi, Kyoto-fu (JP); Mori, Kazuhiro, Katano-shi, Osaka-fu (JP)
(74) Representative: Eisenführ, Speiser & Partner

(56) References cited:
- EP-A- 0 296 019
- US-A- 4 849 858
- PATENT ABSTRACTS OF JAPAN vol. 016 no. 267 (E-1217) ,16 June 1992 & JP-A-04 061747 (NIPPON STEEL CORP;OTHERS: 01) 27 February 1992,
- PATENT ABSTRACTS OF JAPAN vol. 017 no. 436 (C-1096) ,12 August 1993 & JP-A-05 097418 (MATSUSHITA ELECTRIC IND CO LTD) 20 April 1993,

## Description

### BACKGROUND OF THE INVENTION

### Field of the Invention

The present invention relates generally to the radiation of heat from an article of manufacture which tends to evolve heat and, more particularly, to a heat radiating member for cooling electric component parts or machine tools which tend to evolve heat.

### Description of Related Art

It is well known that, for example, high power electronic component parts such as high power transistors are generally provided with an aluminum heat sink for dissipating heat evolved therein during the operation thereof. For a similar purpose, certain printed circuit boards having IC and/or LSI component parts mounted thereon and evolving heat make use of a substrate in the form of a metallic plate made of aluminum or the like. In either case, the heat sink and the metallic plate serve as a heat radiating member for cooling the component parts by dissipating heat.

Hitherto, for radiating heat evolved in and from the electric component parts tending to evolve heat, a heat radiating member generally made of aluminum has been used. Of various metals, aluminum has a relatively low specific gravity sufficient to contribute to a reduction in weight of the component part. Aluminum also has excellent thermal and electrical conductivities and is therefore utilized as predominant material for the heat radiating member.

To meet a recent need to further reduce the size of the electronic component parts and also to realize a high density integration of the electronic component parts, the heat radiating member currently employed need be further reduced in weight and size. With the heat radiating member made of aluminum. however, the thickness and the size of the aluminum plate used as the heat radiating member are generally determined depending on the thermal conductivity peculiar to aluminum and, therefore, reduction in size of the heat radiating member is limited.

In addition, application of the aluminum heat radiating member is limited. Specifically, to miniaturize the circuit substrate, attempts have been made to make the circuit substrate of a synthetic resin having a flexibility. The aluminum circuit substrate cannot be used for such applications.

In the Japanese patent application JP-A-5 097 418 it is proposed to produce graphite in form of block. According to this publication, a highly oriented graphite block is obtained by applying pressure to plural sheets of material at a high temperature.

In the Japanese patent application JP-A-4 061 747 there is disclosed a negative electrode for a lithium secondary battery in which a carbon fiber is used to enhance the stability of the discharge capacity. The carbon fiber is disclosed having an orientation factor FWHM in the area of 7-20deg.

EP-A-0296019 discloses a mounting that forms a heat sink for printed circuit boards comprising a graphite core oriented by compression to obtain very high lateral thermal conductivity and relatively low density. This core is held by two outer skins made up of folds of carbon fibers embedded in an epoxy resin matrix. A metallic frame made of invar makes the mounting rigid.

### SUMMARY OF THE INVENTION

The present invention has been developed to overcome the above-described disadvantages.

It is accordingly an objective of the present invention to provide an improved heat radiating member having a reduced size and a reduced weight.

Another objective of the present invention is to allow a flexible circuit substrate to concurrently serve as a heat radiating member.

In accomplishing the above and other objectives, there is provided a heat radiating member for cooling an article of manufacture, said heat radiating member comprises a heat conducting sheet made of highly oriented graphite said heat conducting sheet having one end connected to said article of manufacture and the other end connected to a heat radiator so that heat evolved in said article of manufacture is conducted to said heat radiator through said heat conducting sheet, characterized in that said graphite has a FWHM-value of not greater than 20 degrees and that said heat conducting sheet is flexible.

The heat radiating member thus provided may be a heat sink for cooling electronic component parts or machine tools tending to evolve heat, a sealing member for sealing an electronic component part, a connecting member for connecting electronic component parts with a heat radiator or a heat radiating member adapted to be used with a circuit substrate on which electronic component parts would be mounted.

Also, preferably the heat radiating member may be a flexible graphite sheet having a specific gravity within the range of 0.5 to 1.5.

According to the present invention, since the heat radiating member is made of highly oriented graphite, the thermal conductivity thereof is high as compared with that of aluminum. Consequently, the heat radiating member can have a reduced size and a reduced weight.

Where the FWHM-value of the graphite is not greater than 20 degrees, the orientation of graphite is highly enhanced and the heat dissipating performance can be increased.

Where the heat radiating member is used as a heat sink for cooling the electronic component parts, the heat sink can have a reduced size and a reduced weight. Moreover, where the heat radiating member is used as a sealing member for sealing the electronic component part, the sealing member can have a reduced size and a reduced weight. Similarly, where the heat radiating member is used as a connecting member for connecting the electronic component parts with the heat radiator, not only can the heat radiating member have a reduced size and a reduced weight, but heat can be efficiently transmitted from the electronic component parts to the heat radiator to accomplish an efficient cooling of the electronic component parts.

Again, where the heat radiating member is used with the circuit substrate, not only can the circuit substrate have a reduced size and a reduced weight, efficient heat dissipation takes place in the circuit substrate to accomplish a self-cooling of the substrate.

If a heat radiating member in the form of a graphite sheet having a flexibility and also having a specific gravity within the range of 0.5 to 1.5 is used as a circuit substrate, the circuit substrate can have a corresponding flexibility. If such heat radiating member is used as a connecting member, not only can reduction in weight be achieved, but the position of the electronic component parts relative to the heat radiator will not be limited.

Where the heat radiating member is used as a heat sink in a machine tool tending to evolve heat, the heat sink can have a reduced size and a reduced weight.

### BRIEF DESCRIPTION OF THE DRAWINGS

The above and other objectives and features of the present invention will become more apparent from the following description of preferred embodiments thereof with reference to the accompanying drawings, throughout which like parts are designated by like reference numerals, and wherein:
Fig. 1 is a schematic perspective view of an electric power unit embodying the present invention;
Fig. 2 is a schematic sectional representation of a power transistor mounted in the electric power unit of Fig. 1;
Fig. 3 is a fragmentary sectional view of a circuit substrate mounted in the electric power unit of Fig. 1;
Fig. 4 is a view similar to Fig. 2, showing another preferred embodiment of the present invention;
Fig. 5 is a schematic elevational view of the circuit substrate, showing a further preferred embodiment of the present invention;
Fig. 6 is a schematic perspective view of a machine tool, showing a still further preferred embodiment of the present invention;
Fig. 7 is a view similar to Fig. 6, showing a modification of the machine tool;
Fig. 8 is a view similar to Fig. 6, showing a different modification of the machine tool;
Fig. 9 is a schematic sectional view, on an enlarged scale, of the tip of the machine tool shown in Fig. 8; and
Fig. 10 is a fragmentary elevational view of an end mill, showing a yet further preferred embodiment of the present invention.

### DETAILED DESCRIPTION OF THE PREFERRED EMBODIMENTS

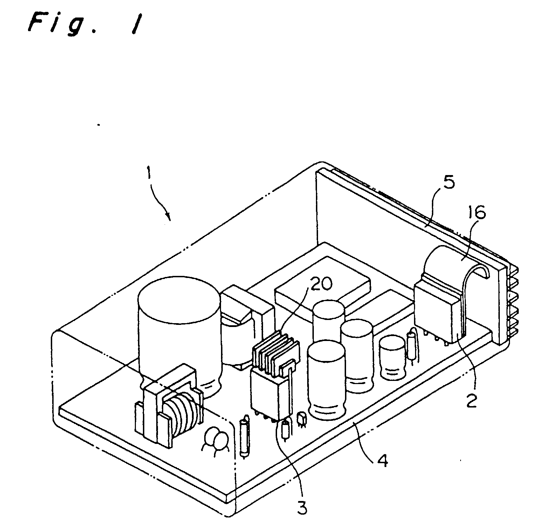

Referring to Fig. 1, an electric power unit 1 shown therein includes various electric component parts such as semiconductor elements including two power IC components 2 and 3, various capacitors, various resistors and transformers. Those electric component parts having respective terminal pins are mounted on one surface of a circuit board 4 with the terminal pins soldered to printed circuits formed on the opposite surface of such circuit board 4.

The circuit board 4 is of a generally rectangular configuration and has an aluminum heat radiator 5 mounted on one end thereof in a heat conducting fashion so as to lie perpendicular thereto. The heat radiator 5 has a number of heat dissipating fins.

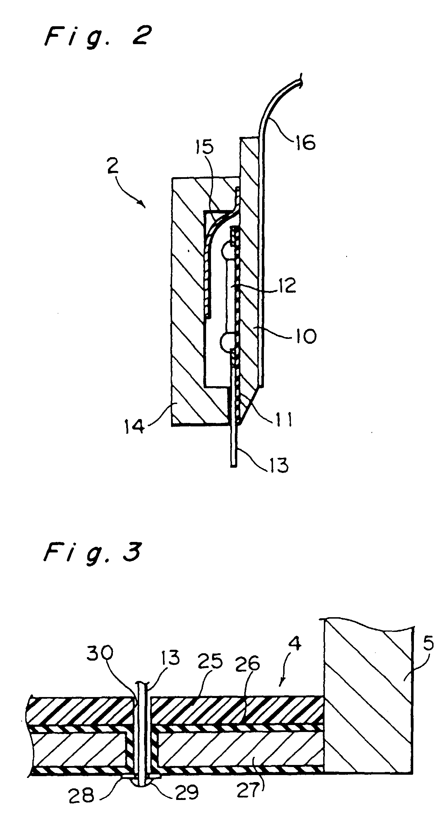

As best shown in Fig. 2, the power transistor 2 comprises a substrate 10, an insulating layer 11 formed on the substrate 10, a transistor element 12 mounted on the substrate 10 with the insulating layer 11 intervening between it and the substrate 10, terminal pins 13 connected with the transistor element 12 through lead wires, and a sealing case 14 for sealing these elements on the substrate 10. The sealing casing 14 and the substrate 10 are connected with a heat conductive sheet 15 made of graphite having a flexibility. The substrate 10 is in turn connected with the heat radiator 5 by means of a heat conductive strip 16 which is in the form of a sheet of graphite having a flexibility.

The power transistor 3 is provided with a heat sink 20 coupled to a substrate of the power transistor. This heat sink 20 is, as will be described in detail later, made of, for example, a pulverized form of graphite having a high degree of orientation (this graphite is hereinafter referred to as highly oriented graphite).

In the illustrated embodiment, the sheet or powder of highly oriented graphite is used as a heat conducting member or a heat sink to enable the heat radiating member of the present invention to be manufactured compact in size and light in weight.

As shown in Fig. 3, the circuit board 4 includes a substrate 25 made of resin such as, for example, polyimide, reinforced epoxy having glass fibers dispersed therein or Bakelite, and a radiating substrate 27 bonded in face-to-face relation to the resinous substrate 25 with an insulating layer 26 intervening between it and the resinous substrate 25. The radiating substrate 27 is in the form of a shaped sheet of highly oriented graphite. A plurality of pin holes, only one of which is shown by 30, for passage of terminal pins 13 are formed in the circuit board 4 so as to extend completely through both of the resinous substrate 25 and the radiating substrate 27. The insulating layer 26 is formed not only on one surface of the radiating substrate 27 adjacent the resinous substrate 25, but also on the opposite surface thereof. Respective segments of the insulating layer 26 on the opposite surfaces of the radiating substrate 27 are continued to each other through parts of the insulating layer 26 each being formed on the wall of a portion of each pin hole 30 that extends through the radiating substrate 27 to avoid an electric shortcircuit between the terminal pins 13 and the radiating substrate 27. An outer surface of the insulating layer segment remote from the radiating substrate 27 is formed with a pattern of printed circuit wirings 28, and the terminal pins 13 inserted through the pin holes 30 are soldered as at 29 to those circuit wirings 28. If desired, an electroconductive paste such as solder deposit may be provided through a through-hole to achieve an electric connection in a multilayered substrate.

As previously described, one end of the circuit board 4 is connected with the heat radiator 5. Accordingly, heat being most transmitted through the terminal pins 13 can be efficiently transmitted to the heat radiator 5 through the radiating substrate 27 to accomplish a cooling.

The manner in which the electric power unit 1 is cooled will now be described.

Assuming that the electric power unit 1 is electrically powered, the power transistors 2 and 3 and the transformers evolve heat. Once the power transistor 2 evolves heat, part of the heat so evolved is conducted to the sealing casing 14 through the heat conducting sheet 15 and in turn to the heat radiator 5 through the metallic substrate 10 and the heat conductive strip 16. Also, it is conducted to the heat radiator 5 through the terminal pins 13 and the radiating substrate 27. Accordingly, even though the power transistor 2 evolves a considerable amount of heat, it can be efficiently cooled. It is to be noted that since in this embodiment heat dissipation takes place through no heat radiating member made of aluminum, the sealing casing 14, the heat conductive strip 16 and the heat radiating substrate 27 can be made compact in size and light-weight.

On the other hand, heat evolved from the power transistor 3 is dissipated in part into the air through the heat sink 20 and in part conducted to the radiating substrate 27 through the terminal pins. The heat so conducted to the radiating substrate 27 is in turn conducted to the heat radiator 5 before it is dissipated into the air. Since the heat sink 20 is made of a powder of graphite and since it is in the form of a heat radiating fin assembly effective to accomplish an efficient heat dissipation, the heat sink 20 can be manufactured compact in size and light in weight as compared with the heat sink made of aluminum.

In the first embodiment of the present invention shown in Figs. 1 to 3, the heat radiating member of the present invention has been described as used in connection with the electric component parts tending to evolve heat during the operation thereof. However, the present invention is equally applicable to a machine tool which will be described subsequently.

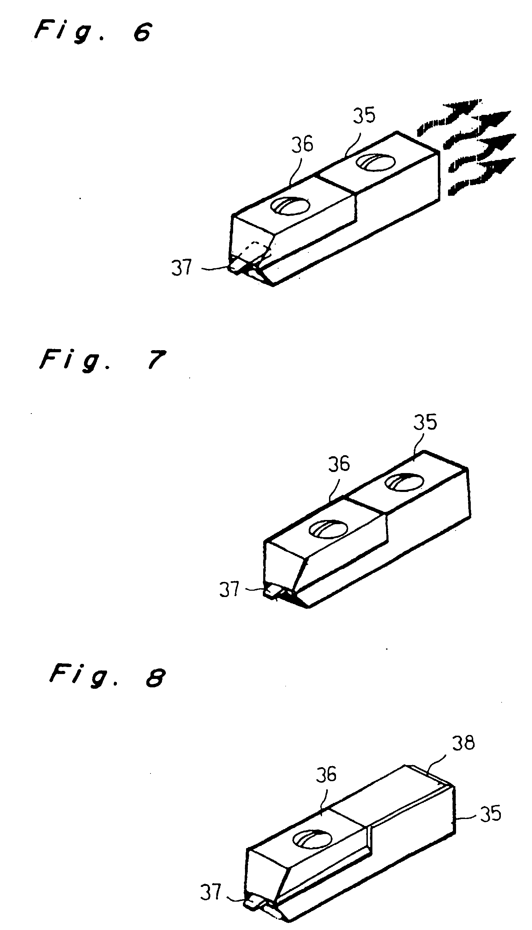

Referring now to Fig. 6 showing a second preferred embodiment of the present invention, the machine tool is shown in the form of a cutter bit. The illustrated cutter bit comprises a generally rod-like shank 35 made of highly oriented graphite and a metallic bit chip 36 mounted on the tip of the shank 35. Graphite crystals forming the shank 35 have planes of orientation aligned in a direction parallel to the direction in which heat is conducted. The bit chip 36 has a tip thereof embedded with a diamond chip 37. With this cutter bit, heat evolved in the diamond chip 37 during machining is conducted to the shank 35 through the bit chip 36 and is then dissipated from a rear end of the shank 35 remote from the bit chip 36. In this example, since the shank 35 is made of highly oriented graphite excellent in heat conductivity, not only can the machine tool be manufactured compact in size and light in weight, but also an efficient heat dissipation is possible.

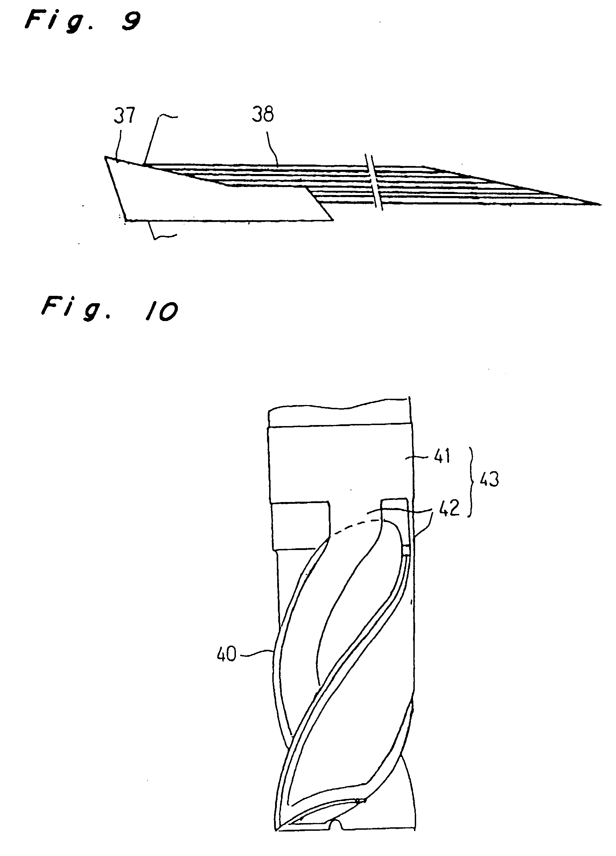

Similar effects can be obtained even if, as shown in Fig. 7, the shank 35 is made of metal and the bit chip 36 is made of highly oriented graphite. In the example shown in Fig. 7, heat evolved in the diamond chip 37 is efficiently dissipated in part through the bit chip 36 and in part through the shank 35.

In an example shown in Fig. 8, a sheet 38 of highly oriented graphite is sandwiched between the bit chip 36 and the shank 35 so as to contact the diamond chip 37. The graphite sheet 38 used therein extends from one end of a gap between the bit chip 36 and the shank 35 adjacent the diamond chip 37 towards the opposite end of such gap and, after having been bent at the rear of the bit chip 36 so as to extend upwardly, extends above the shank 35. As best shown in Fig. 9, at a region of contact of the graphite sheet 38 with the diamond chip 37, the graphite sheet 38 has its front end contacting upper and rear surfaces of the diamond chip 37 with its graphite crystals oriented so as to align with a horizontal plane. Also, a rear end of the graphite sheet 39 is cut slantwise to facilitate heat dissipation.

In any of the foregoing examples, all elements of the cutter bit except for the diamond chip 37 may be made of highly oriented graphite.

Fig. 10 illustrates a third preferred embodiment of the present invention in which the concept of the present invention is applied to an end mill for a milling machine. The illustrated end mill comprises a helically fluted shaft 40 and a cooling member 43 serving as a heat radiating member. The cooling member 43 includes a flexible graphite sheet 41 of 10 to 100 micron in thickness wound around an upper portion of the end mill 40 to assume a generally ring-shape and a plurality of flexible graphite strips 42 all extending spirally downwardly from the ring-shaped graphite sheet 41, each of said graphite strips 42 being positioned between neighboring spiral blades of the end mill 40. In this structure, heat evolved in blade tips of the end mill 40 is conducted to the graphite sheet 41 through the graphite strips 42 before it is dissipated into the air. Because of this, the end mill 40 can be efficiently cooled, minimizing the amount of liquid coolant necessary to cool the end mill 40.

A highly oriented graphite material employed as material for the heat radiating member of the present invention may be a highly crystallized graphite having graphite crystals oriented in one direction. The highly crystallized graphite having a locking property (a FWHM-value measured with the use of an X-ray) not greater than 20 degrees is preferred. The graphite material may be the one obtained by laminating carbon atoms on a substrate by means of a chemical vapor deposition technique using hydrocarbon gas and then by annealing the substrate or may be in the form of a graphitized film of a specific polymer compound. However, the use of the graphitized film of the polymer compound is preferred because of its excellent thermal conductivity. The locking property referred to in the specification is measured at a peak value of graphite (0002) lines with the use of a commercially available Rigaku Denki RU-200B X-ray diffractometer.

The polymer compound referred to above may be the one selected from the group consisting of polyoxadiazoles (PODs), polybenzthiazole (PBT), polybenzbisthiazole (PBBT), polybenzoxazole (PBO), polybenzbisoxazole (PBBO), various polyimides (PIs), various polyamides (PAs), polyphenylene benzimidazole (PBI), polyphenylene benzbisimidazole (PPBI), polythiazole (PT), and poly-paraphenylene vinylene (PPV).

The polyoxadiazoles referred to above include poly-para-phenylene-1,3,4-oxyadiazole and its isomers.

The polyimides referred to above include aromatic polyimides expressed by the following general chemical formulas.

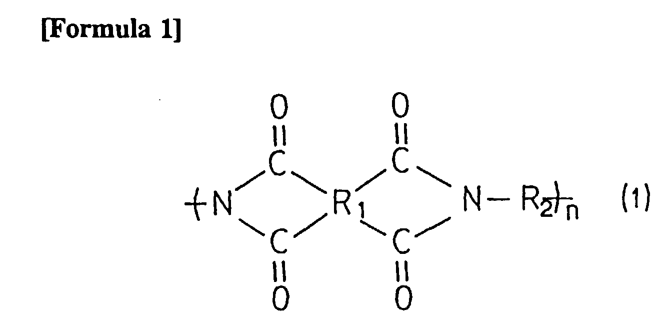

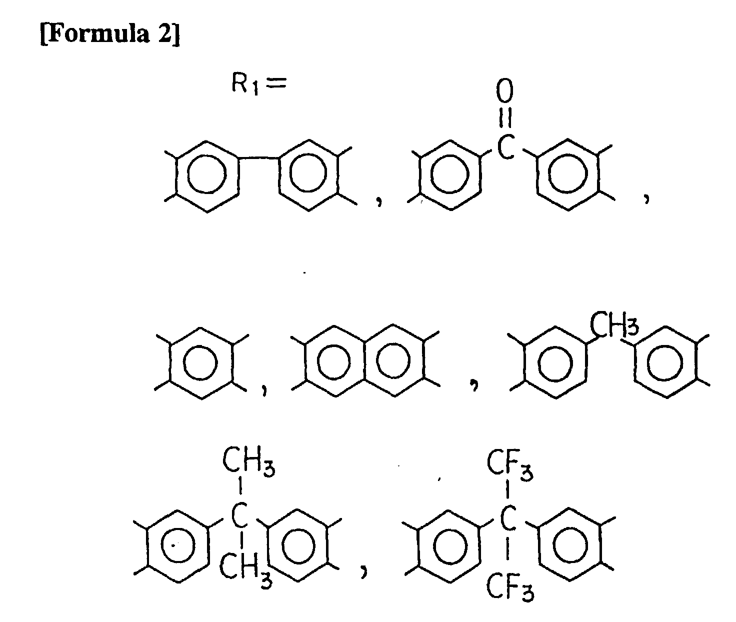

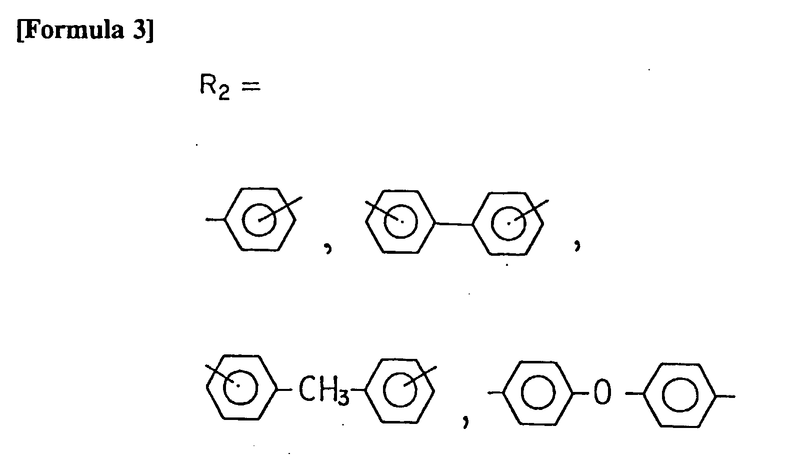

The polyamides referred to above include aromatic polyamides expressed by the following general chemical formula.

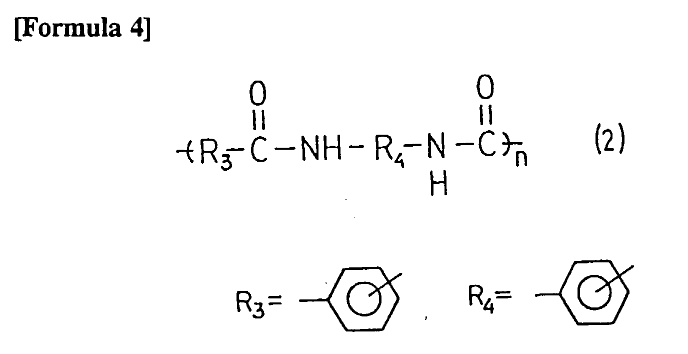

Any of the polyimides and the polyamides which may be employed in the present invention may not be limited to those expressed by the foregoing general formulas.

Any suitable calcining conditions may be employed to graphitize a film of the polymer compound, but calcination at a temperature sufficient to allow the film of the polymer compound to be heated to 2,000°C or higher, preferably to a temperature region of about 3,000°C is preferred to produce the highly oriented graphitized film. This calcination is generally carried out under the atmosphere of an inert gas. In order to suppress any possible influence which may be brought about by gases generated during the graphitization that is effected under a pressurized atmosphere during the calcination, it is preferred that the film of the polymer compound has a thickness not smaller than 5*µ*m. The pressure employed during the calcination may vary depending on the thickness of the film of the polymer compound, but is generally preferred to be within the range of 0.1 to 50 kg/cm². Where calcination is carried out at a maximum temperature not higher than 2,000°C, the resultant graphite would be hard and fragile. The calcination may be followed by rolling, if necessary. Graphitization of the film of the polymer compound may be carried out by cutting the film of the polymer compound to a desired size to provide a plurality of, for example, about 1,000, shaped sheets of the polymer compound, laminating the 1,000 shaped sheets one above the other to provide a laminar structure, loading the laminar structure into a calcining furnace to heat it to a temperature of 3,000°C to initiate graphitization. After the calcination, the resultant graphite material may be rolled if so desired.

The resultant highly oriented graphite material may be in the form of a film, sheet or plate. Moreover, it shall have a flexibility. By way of example, the highly oriented graphite material and having no flexibility, which is obtained by calcining the aromatic polyimide, has a specific gravity of 2.25 (as compared with 2.67 exhibited by aluminum), a thermal conductivity of 860 Kcal/m·h·°C (2.5 times of that of copper and 4.4 times of that of aluminum) with respect to the direction of an A-B plane (the direction in which planes of orientation of crystals extend), an electrical conductivity of 250,000 S/cm with respect to the direction of the A-B plane, and a modulus of elasticity of 84,300 kgf/mm² with respect to the direction of the A-B plane.

While the highly oriented graphite material having a flexibility has a specific gravity (0.5 to 1.5) smaller than that of the highly oriented graphite material having no flexibility, the thermal conductivity does not change so much and it can be shaped into any desired shape, for example, into a heat conducting strip, a heat conducting sheet or a heat conducting substrate and, therefore, the highly oriented graphite material having a flexibility is more preferred.

Where the highly oriented graphite material is employed in the form of a film, a film of the polymer compound which is used as material therefor preferably has a thickness not greater than 400 µm and, more preferably within the range of 5 to 200 µm. If the film of the polymer compound exceeds the uppermost limit of 400 µm, the film will be disintegrated into pieces under the influence of gases generated internally of the film during the heat treatment and will hardly be utilized singly as a material for good electrodes.

However, even the graphite material in a disintegrated state may become a useful graphite film having planes of orientation aligned with each other if mixed with a fluorine resin such as, for example, polytetrafluoroethylene known as Teflon to form a composite.

Also, the highly oriented graphite material discussed above may, after having been pulverized to form a scaly powder, be mixed with a polymer resin such as a fluorine resin to form a composite which may be subsequently used to form the heat sink 20, the sealing casing 14 or the shank 35. In the case of the composite, the weight-based ratio of the graphite material relative to the polymer resin is preferably within the range of 50:1 to 2:1. If the heat radiating member is formed by extruding the composite, carbon crystals are oriented in a direction perpendicular to the direction of extrusion and, therefore, the resultant heat radiating member will exhibit a favorable heat conductivity in that direction.

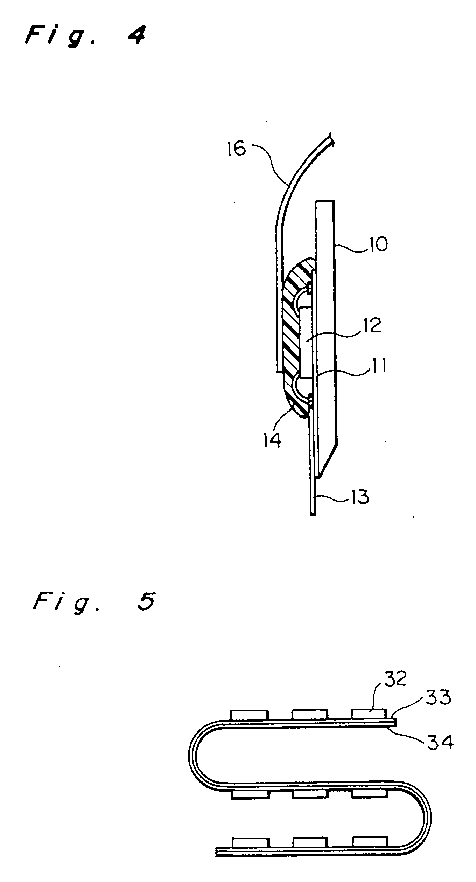

Although the present invention has been described in connection with the preferred embodiments thereof with reference to the accompanying drawings, it is to be noted that various changes and modifications are apparent to those skilled in the art. By way of example, the substrate 10 of the power transistor 2 may be made of resin, metal or the highly oriented graphite material, while the sealing casing 14 made of resin for bare IC components may have a surface connected with the heat conductive strip 16, as shown in Fig. 4.

Also, as shown in Fig. 5, where a flexible film substrate 33 is used for the circuit board, a flexible graphite sheet 34 which is coordinated with the flexible film substrate 33 having electronic component parts 32 mounted thereon may be employed. In this case, by bending the film substrate 30, the volume of space occupied by the substrate 30 can be reduced.

In addition, the present invention is equally applicable to a heat radiating member for use with a single-sided circuit board having various electronic component parts mounted on only one surface thereof or a double-sided circuit board having various electronic component parts mounted on both surfaces thereof.

Finally, the electronic component parts which may evolve heat may not be always limited to the power transistor, and they may include semiconductors such as, for example, MPU, resistors, capacitors, transformers and any other component parts that evolve heat.

Accordingly, such changes and modifications are to be understood as being included within the scope of the present invention as defined by the appended claims, unless they depart therefrom.

## Claims

1. A heat radiating member for cooling an article of manufacture (12), said heat radiating member comprises a heat conducting sheet (16) made of highly oriented graphite, said heat conducting sheet (16) having one end connected to said article of manufacture (12) and the other end connected to a heat radiator (5) so that heat evolved in said article of manufacture (12) is conducted to said heat radiator (5) through said heat conducting sheet (16),
characterized in that said graphite has a FWHM-value of not greater than 20 degrees and that said heat conducting sheet (16) is flexible.

2. The heat radiating member according to claim 1,
wherein said flexible heat conducting sheet (16) has a specific gravity within a range of 0.5 to 1.5.

3. The heat radiating member according to claim 2,
wherein said flexible heat conducting sheet (16) is made by graphitizing a polymer film that has a thickness not greater than 400 *µ*m and is selected from the group consisting of polyoxadiazoles, polybenzthiazole, polybenzbisthiazole, polybenzoxazole, polybenzbisoxazole, polyimides, polyamides, polyphenylene benzimidazole, polyphenylene benzbisimidazole, polythiazole and poly-paraphenylene vinylene, said polymer film being graphitized at a temperature not less than 2,000°C and then rolled.

4. The heat radiating member according to claim 2,
wherein said article of manufacture is an electronic component part.

5. The heat radiating member according to claim 4,
wherein said article of manufacture (12) and said heat radiator (5) are both mounted on a circuit board.

## Patentansprüche

1. Wärmeabstrahlelement zum Kühlen eines Fertigungsgegenstandes (12), das eine Wärmeleitbahn (16) aus einem hochorientierten Graphit enthält, wobei die Wärmeleitbahn (16) ein mit dem Fertigungsgegenstand (12) verbundenes Ende sowie ein weiteres Ende aufweist, das mit einem Wärmestrahler (5) so verbunden ist, daß die Wärme, die von dem Fertigungsgegenstand (12) abgegeben wird, über die Wärmeleitbahn (16) zum Wärmestrahler (5) geführt wird,
**dadurch gekennzeichnet,** daß der Graphit einen FWHM-Wert von nicht größer als 20 Grad besitzt und daß die Wärmeleitbahn (16) flexibel ist.

2. Wärmeabstrahlelement nach Anspruch 1,
bei dem die flexible Wärmeleitbahn (16) ein spezifisches Gewicht innerhalb eines Bereiches von 0,5 bis 1,5 besitzt.

3. Wärmeabstrahlelement nach Anspruch 2,
bei dem die flexible Wärmeleitbahn (16) durch Graphitierung einer Polymerschicht hergestellt wird, die eine Dicke von nicht größer als 400 *µ*m besitzt und die aus der Gruppe ausgewählt ist, bestehend aus Polyoxadiazolen, Polybenzthiazol, Polybenzbisthiazol, Polybenzoxazol, Polybenzbisoxazol, Polyimiden, Polyamiden, Polyphenylen Benzimidazol, Polyphenylen, Benzbisimidazol, Polythiazol und Poly-paraphenylenvinylen, wobei die Polymerschicht bei einer Temperatur von nicht weniger als 2000° C graphitiert und anschließend gewalzt wird.

4. Wärmeabstrahlelement nach Anspruch 2,
bei dem der Fertigungsgegenstand ein elektronisches Bauteil ist.

5. Wärmeabstrahlelement nach Anspruch 4,
bei dem sowohl der Fertigungsgegenstand (12) als auch der Wärmestrahler (5) auf einer Schaltungsplatine montiert sind.

## Revendications

1. Elément rayonnant la chaleur pour refroidir un article fabriqué (12),
ledit élément rayonnant la chaleur comprenant une feuille conductrice de chaleur (16) faite en graphite hautement orienté, ladite feuille conductrice de chaleur (16) ayant une extrémité connectée audit article fabriqué (12) et l'autre extrémité connectée à l'élément (5) rayonnant la chaleur, de manière à ce que la chaleur produite par ledit article fabriqué (12) soit amenée audit élément (5) rayonnant la chaleur, par l'intermédiaire de ladite feuille (16) conductrice de chaleur, caractérisé en ce que ledit graphite a une valeur FWHM ne dépassant pas 20 degrés et que ladite feuille (16) conductrice de chaleur est flexible.

2. Elément rayonnant la chaleur selon la revendication 1, dans lequel ladite feuille flexible (16) conductrice de chaleur a un poids spécifique dans la plage de 0,5 à 1,5.

3. Elément rayonnant la chaleur selon la revendication 2, dans lequel ladite feuille flexible (16) conductrice de chaleur est obtenue par la graphitisation d'un film polymère qui a une épaisseur ne dépassant pas 400 µm et qui est choisi dans le groupe constitué pas les polyoxadiazoles, le polybenzthiazole, le polybenzbisthiazole, le polybenzoxazole, le polybenzbisoxazole, les polyimides, les polyamides, le polyphénylène benzimidazole, le polyphénylène benzbisimidazole, le polythiazole et le polyparaphénylène vinylène, ledit film polymère ayant subi une graphitisation à une température qui n'est pas inférieure à 2000 °C et qui est ensuite laminé.

4. Elément rayonnant la chaleur selon la revendication 2, dans lequel ledit article fabriqué est un élément constitutif électronique.

5. Elément rayonnant la chaleur selon la revendication 4, dans lequel ledit article fabriqué (12) et ledit élément (5) rayonnant la chaleur sont montés tous deux sur une plaquette à circuits imprimés.
